# EUROPÄISCHE PATENTSCHRIFT

(11) **EP 1 388 205 B1**
(45) Veröffentlichungstag und Bekanntmachung des Hinweises auf die Patenterteilung: **10.08.2005**
(21) Anmeldenummer: 02724116.5
(22) Anmeldetag: 20.03.2002
(51) Int. Cl.: H03G 3/30

(54) **VORRICHTUNG UND VERFAHREN ZUR REGELUNG DER AUSGANGSLEISTUNG VON MOBILFUNKSTATIONEN**
DEVICE AND METHOD FOR REGULATING THE OUTPUT POWER OF MOBILE RADIO TELEPHONE STATIONS
DISPOSITIF ET PROCEDE DE REGLAGE DE LA PUISSANCE DE SORTIE DE STATIONS RADIOTELEPHONIQUES MOBILES

(30) Priorität: 17.05.2001 DE 10124179
(43) Veröffentlichungstag der Anmeldung: 11.02.2004
(73) Patentinhaber: Infineon Technologies AG, 81669 München (DE)
(72) Erfinder: WENZEL, Dietmar, 81549 München (DE); WÜRTH, Robert, 81827 München (DE)
(74) Vertreter: Lange, Thomas, Dr.
(86) Internationale Anmeldenummer: PCT/DE2002/001016
(87) Internationale Veröffentlichungsnummer: WO 2002/093759

(56) Entgegenhaltungen:
- EP-A- 1 087 541
- WO-A-01/47106
- US-A- 5 369 789
- US-A- 5 778 307
- US-A- 5 990 755
- US-A1- 2001 000 456

## Beschreibung

Die Erfindung betrifft eine Vorrichtung zur Regelung der Ausgangsleistung von Funkgeräten, und insbesondere von Mobilfunkgeräten. Des weiteren betrifft die Erfindung ein Verfahren zum Herauf- bzw. Herunterfahren der Sendeleistung von Funkgeräten, und insbesondere von Mobilfunkgeräten.

Bei der Übertragung von gepulsten Mobilfunk-Sendesignalen stellt sich das Problem, dass die Sendeleistung zu Beginn des Sendevorgangs innerhalb einer gewissen Zeitspanne auf ihren Sollwert hochgefahren werden muss, bevor der zu sendende Datenburst abgestrahlt werden kann. Nach der Übermittlung des Datenbursts muss die Sendeleistung wieder näherungsweise auf Null heruntergefahren werden. Dabei darf das Ein- und Ausschalten der Sendeleistung nicht abrupt erfolgen, denn dies würde zu einem Störspektrum führen, das insbesondere die Übertragungsqualität auf den benachbarten Kanälen stark in Mitleidenschaft ziehen würde. Insofern sehen die gängigen Mobilfunkstandards vor, dass die Nachbarkanalstörungen ein vorgegebenes Höchstmaß nicht übersteigen dürfen.

Aus diesem Grund muss das Ein- und Ausschalten der Sendeleistung kontinuierlich über eine gewisse Zeitspanne hinweg in Form einer Leistungsrampe erfolgen. Dies erfordert eine zuverlässige Regelung der Ausgangsleistung über einen hohen Dynamikbereich hinweg. Der geforderte Dynamikbereich der Ausgangsleistung beträgt beispielsweise bis zu 48 dB. Hinzu kommt, dass für jeden zu übermittelnden Datenburst ein Einschalt- sowie ein Ausschaltvorgang erforderlich ist.

Beim GSM-Mobilfunksystem, das mit dem Modulationsverfahren GMSK (Gaussian Minimum Shift Keying) arbeitet, wurde das geschilderte Problem mit Hilfe von aufwendiger Schaltungstechnik beim Leistungsverstärker und dessen Regelung gelöst. Auf diese Weise war es möglich, den geforderten Dynamikbereich mit der nötigen Genauigkeit einzuhalten. Bei der EDGE-Erweiterung des Mobilfunksystems GSM stellt sich das Problem einer zuverlässigen Kontrolle der Ausgangsleistung jedoch in verschärfter Form, da hier sowohl die Phasen- wie auch die Amplitudeninformation linear von der Endstufe übertragen werden muss.

US 5 778 307 offenbart einen Sendeverstärker mit einer Skaliereinheit für das Basisbandsignal.

Aufgabe der Erfindung ist es daher, eine Vorrichtung sowie ein Verfahren zur Kontrolle der Ausgangsleistung von Funkgeräten, insbesondere von Mobilfunkgeräten zur Verfügung zu stellen, womit sich der Einschalt- und Ausschaltvorgang der Sendeleistung des Funkgeräts über einen großen Dynamikbereich hinweg mit geringem Aufwand zuverlässig kontrollieren lässt.

Diese Aufgabe der Erfindung wird durch eine Vorrichtung zur Kontrolle der Ausgangsleistung von Funkgeräten gemäß Anspruch 1, sowie durch ein Verfahren zum Herauf- bzw. Herunterfahren der Sendeleistung von Funkgeräten gemäß den Ansprüchen 16 und 17 gelöst.

Die erfindungsgemäße Vorrichtung zur Kontrolle der Ausgangsleistung von Funkgeräten, insbesondere von Mobilfunkgeräten umfasst mindestens einen Hochfrequenzbaustein, welcher Basisband-Sendesignale in den Hochfrequenzbereich umsetzt und verstärkt. Der Hochfrequenz-Baustein selbst umfasst einen Leistungsverstärker mit einstellbarer Verstärkung. Zur Kontrolle der Ausgangsleistung weist die Vorrichtung zusätzlich eine Skaliereinheit auf, mit der die Signalamplituden der Basisband-Sendesignale variierbar sind. Ferner beinhaltet die Vorrichtung ein Steuergerät, welches bei Herauf- oder Herunterfahren der Ausgangsleistung vor bzw. nach der Übermittelung eines Datenbursts die Veränderung der Signalamplituden der Basisband-Sendesignale durch die Skaliereinheit mit der Veränderung der Verstärkung des Leistungsverstärkers synchronisiert.

Während die Sendeleistung bisher ausschließlich durch Variieren des Verstärkungsfaktors des Leistungsverstärkers geregelt wurde, wird erfindungsgemäß eine zweite Regelungsmöglichkeit zur Beeinflussung der Sendeleistung eingeführt, welche mit der ersten Möglichkeit über das Steuergerät synchronisiert wird. Noch bevor die Basisband-Sendesignale zu dem im Hochfrequenzbaustein angeordneten Leistungsverstärker gelangen, können ihre Signalamplitude mit Hilfe der erfindungsgemäßen Skaliereinheit beeinflusst werden. Der überwiegende Teil der Leistungsregelung erfolgt auch weiterhin durch Variieren der Verstärkung des Leistungsverstärkers. Indem jedoch zusätzlich ein zweiter Regelungsmechanismus vorgesehen wird, der die Amplituden der Eingangssignale beeinflusst, verringert sich der von jedem einzelnen Regelmechanismus zu bewältigende Dynamikbereich. Durch die Dämpfung der Signalamplituden der Basisband-Sendesignale wird erreicht, dass der Leistungsverstärker selbst nur mehr über einen geringeren Dynamikbereich hinweg geregelt werden muss. Dadurch wird der Schaltungsaufwand zur Regelung der Verstärkung des Leistungsverstärkers verringert.

Die Erfindung kann auch zur Erhöhung des für die Ausgangsleistung zur Verfügung stehenden Dynamikbereichs verwendet werden. Dieser Dynamikbereich vergrößert sich um den Betrag der durch die erfindungsgemäße Skaliereinheit zusätzlich verursachten Dämpfung. Dadurch kann während des Einschalt- bzw. Ausschaltvorgangs ein Übersprechen des Eingangssignals auf das Ausgangssignal wirksam verhindert werden. Vor dem Beginn der Übermittlung eines Datenbursts ist das Eingangssignal hinreichend gut vom Ausgang isoliert, so dass keine Störgeräusche gesendet werden. Dasselbe gilt für die Zeitspanne nach Abschluss des Sendevorgangs.

Die Erfindung ermöglicht es, die Isolationsanforderung des Leistungsverstärkers bezüglich des Übersprechens des Eingangssignals auf das Ausgangssignal zu verringern, und zwar genau um den Betrag der Dämpfung der Basisband-Sendesignale mit Hilfe der erfindungsgemäßen Skaliereinheit.

Ein weiterer Vorteil der erfindungsgemäßen Lösung ist, dass das Stellsignal für die Regelung der Verstärkung des Leistungsverstärkers nur mehr einen kleineren Wertebereich umfasst als bisher, da der Leistungsverstärker nur mehr über einen geringeren Dynamikbereich als bisher geregelt werden muss. Störungen, die auf das Stellsignal einwirken, verlieren daher an Bedeutung; die Robustheit der Regelung wird verbessert.

Ein weiterer Vorteil ist, dass sich die erfindungsgemäße Skaliereinheit mit geringem baulichen Zusatzaufwand implementieren lässt. Auch unter Kostengesichtspunkten stellt sich die erfindungsgemäße Lösung wesentlich vorteilhafter dar als jeder Versuch, den regelbaren Dynamikbereich des Leistungsverstärkers mit Hilfe aufwendiger Schaltungstechnik weiter zu erhöhen.

Es ist von Vorteil, wenn die Skaliereinheit für jedes Basisband-Sendesignal einen Multiplizierer umfasst, mit dem die Signalamplitude des jeweiligen Basisbandsignals skaliert werden kann. Dadurch ist es möglich, jede gewünschte Dämpfung durch Multiplikation der jeweiligen Signalamplitude mit dem entsprechenden Faktor zu erhalten. Auf diese Weise kann jede benötigte Dämpfung und jeder beliebige Dämpfungsverlauf flexibel realisiert werden. Ein weiterer Vorteil ist, dass die Skalierung mit Hilfe eines Multiplizierers innerhalb von sehr kurzen Zeitintervallen verändert werden kann.

Insbesondere ist es von Vorteil, wenn es sich bei den Multiplizierern um digitale Multiplizierer handelt, die im Signalpfad vor den Digital-/Analog-Wandlern angeordnet sind. Bei dieser Ausführungsform der Erfindung erfolgt die Skalierung der Signalamplituden nicht im Leistungsbereich der Schaltungsanordnung, sondern in dem Bereich, in dem das Basisbandsignal noch als digitales Signal vorliegt. In diesem Bereich der Schaltung können die Signalamplituden der jeweiligen Basisbandsignale in einfacher und kostengünstiger Weise mit Hilfe von digitalen Multiplizierern beeinflusst werden. Digitale Multiplizierer bieten eine hinreichende Genauigkeit und Schnelligkeit, um die Basisbandsignale unter Beibehaltung von deren Phase zu skalieren.

Es ist von Vorteil, wenn die Vorrichtung mindestens einen Basisband-Baustein umfasst, der die Basisbandsignale erzeugt, und wenn die Skaliereinheit auf dem Basisband-Baustein angeordnet ist. Auf dem Basisband-Baustein wird eine digitale Signalverarbeitung der Basisbandsignale durchgeführt. Anschließend wird das Basisbandsignal digital-/analog-gewandelt und dem bzw. den Hochfrequenzbausteinen zugeführt. Insofern bietet es sich an, die Skaliereinheit in Digitaltechnik auszuführen und auf dem Basisband-Baustein zu integrieren. Dies hat auch den Vorteil, dass sich komplexe, an- bzw. absteigende Amplitudenverläufe in digitaler Form abspeichern lassen.

Gemäß einer vorteilhaften Ausführungsform der Erfindung umfassen die Basisband-Sendesignale ein Inphase- sowie ein Quadratursignal. In der Mobilfunktechnik werden Signale üblicherweise in der komplexen Ebene dargestellt. Dies bedeutet, dass ein komplexes Basisband-Sendesignal mittels eines reellwertigen Inphasesignals sowie eines reellwertigen Quadratursignals dargestellt wird.

Vorteilhafterweise ist die Verstärkung des Leistungsverstärkers durch eine Leistungsregelung steuerbar. Derartige regelbare Leistungsverstärker sind aus dem Stand der Technik bekannt und lassen sich in vorteilhafter Weise mit der erfindungsgemäßen Skaliereinheit kombinieren. Es stehen somit zwei unabhängig voneinander arbeitende Regelungsmechanismen zur Beeinflussung der Ausgangsleistung zur Verfügung: Zum einen kann die Ausgangsleistung wie bisher über die Leistungsregelung des Leistungsverstärkers vorgenommen werden. Zusätzlich kann die Ausgangsleistung des Funkgeräts durch die erfindungsgemäße Skaliereinheit beeinflusst werden, welche insofern einen zweiten Regelungsmechanismus darstellt. Da beide Regelungsmechanismen unabhängig voneinander arbeiten, lässt sich durch Kombination der erfindungsgemäßen Amplitudenskalierung mit der am Leistungsverstärker vorgenommenen Leistungsregelung der Dynamikbereich erhöhen.

Dabei ist es von Vorteil, wenn die Verstärkung des Leistungsverstärkers durch die Leistungsregelung so nachgeregelt wird, dass die tatsächliche Sendeleistung jeweils einem der Leistungsregelung zugeführten Sollwert der Sendeleistung entspricht. Mit dem Sollwert wird also nicht der Verstärkungsfaktor vorgegeben, sondern die gewünschte tatsächliche Sendeleistung, die man sich als Produkt der Eingangssignalamplitude und des Verstärkungsfaktors des Leistungsverstärkers veranschaulichen kann.

Die eigentliche Leistungsregelung erfolgt mit Hilfe eines Regelkreises, bei dem der zugeführte Sollwert der Sendeleistung mit der tatsächlich gemessenen Sendeleistung verglichen wird. Entsprechend der Abweichung zwischen Istwert und Sollwert wird dann der Verstärkungsfaktor durch die Leistungsregelung so verändert, dass die tatsächliche Sendeleistung dem Sollwert angenähert wird. Auf diese Weise wird die Signalamplitude des Eingangssignals automatisch mit berücksichtigt: Der Verstärkungsfaktor wird so eingestellt, dass der Eingangssignalpegel auf die mittels des Sollwerts vorgegebene Ausgangsleistung hochverstärkt wird. Dadurch, dass als Sollwert die gewünschte Ausgangssendeleistung vorgegeben wird, ist eine sehr einfache Regelung des Herauf- und Herabfahrens der Ausgangssendeleistung möglich.

Es ist von Vorteil, wenn die Vorrichtung eine Leistungsmesseinheit zur Bestimmung der tatsächlichen Sendeleistung aufweist, welche einen Bruchteil der Sendeleistung auskoppelt und auswertet. Direkt an der Antenne wird ein Teil der Ausgangssendeleistung ausgekoppelt und vorteilhafterweise gleichgerichtet und stellt ein Maß für die tatsächliche Ausgangssendeleistung dar. Das so erhaltene Signal dient als Istwert für den oben beschriebenen Leistungsregelkreis. Da die Leistung direkt an der Antenne und nicht etwa an einer vorgeordneten Stelle im Signalpfad erfasst wird, kann der aktuelle Wert der Ausgangssendeleistung zutreffend bestimmt werden. Dadurch wird die Genauigkeit der Regelung erhöht.

Vorteilhafterweise umfasst die Vorrichtung einen Leistungsrampen-Generator zur Erzeugung von stetig verlaufenden Einschalt- bzw. Ausschaltrampen für den Sollwert der Sendeleistung. Mit Hilfe einer stetig verlaufenden Einschaltrampe wird sichergestellt, dass die Ausgangssendeleistung vor dem Beginn des Sendevorgangs kontinuierlich und stetig von Null auf den gewünschten Sendeleistungswert hochgefahren wird. Entsprechend dient die Ausschaltrampe dazu, die Sendeleistung nach Beendigung des Sendevorgangs wieder kontinuierlich auf näherungsweise Null zurückzufahren, wobei abrupte Veränderungen der Ausgangssignalleistung vermieden werden. Dadurch kann das Ausmaß der Nachbarkanalstörungen unterhalb des erlaubten Grenzwerts gehalten werden.

Gemäß einer vorteilhaften Ausführungsform der Erfindung wird der Leistungsrampen-Generator auf dem Baustein angeordnet, der die Skaliereinrichtung enthält. Hier ist es insbesondere von Vorteil, sowohl die Skaliereinrichtung als auch den Leistungsrampen-Generator in Digitaltechnik zu realisieren und auf dem Basisband-Baustein zu integrieren. Der Leistungsrampen-Generator erzeugt bei dieser Ausführungsform der Erfindung ein ansteigendes bzw. abfallendes Digitalsignal, welches mit Hilfe eines Digital-/Analog-Wandlers in einen analogen Sollwert der Sendeleistung umgesetzt wird. Dieser analoge Sollwert der Sendeleistung kann dann der Leistungsregelung des Leistungsverstärkers zugeführt werden.

Alternativ dazu wäre es möglich, sowohl den Leistungsrampen-Generator als auch die Skaliereinrichtung in analoger Technik zu realisieren und auf dem Hochfrequenzbaustein anzuordnen. Dies hätte den Vorteil, dass die Digital-/Analog-Wandlung des digitalen Sollwertsignals entfallen könnte.

Eine vorteilhafte Ausführungsform der Erfindung sieht vor, dass die Skaliereinheit einen Speicher für eine Abfolge von an- bzw. absteigenden Skalierungswerten aufweist, womit ein an- bzw. absteigender Verlauf der Amplituden der Basisband-Sendesignale erzeugbar ist. Diese Skalierungswerte können beispielsweise nacheinander den Multiplizierern der Skaliereinheit als Faktoren zugeführt werden. Die an den Multiplizierern anliegenden Basisband-Sendesignale können dann nacheinander mit den verschiedenen aufeinanderfolgenden Skalierungswerten multipliziert werden, so dass sich ein an- bzw. absteigender Verlauf der Amplituden der Basisband-Sendesignale erzeugen lässt. Anstatt die Skalierung abrupt zu wechseln, wird dadurch eine annähernd kontinuierliche Veränderung der skalierten Signalamplituden ermöglicht.

Es ist von Vorteil, wenn der an- bzw. absteigende Verlauf der Basisband-Sendesignale durch Triggersignale initiiert wird, die der Skaliereinheit zugeführt werden. Beispielsweise kann ein erstes Triggersignal vorgesehen sein, das einen ansteigenden Verlauf der Amplituden der Basisband-Sendesignale hervorruft. Entsprechend kann ein zweites Triggersignal vorgesehen sein, welches einen absteigenden Verlauf der Amplituden initiiert. Es muss daher nicht die gesamte Abfolge von an- bzw. absteigenden Skalierungswerten an die Skaliereinheit übermittelt werden. Statt dessen reicht es aus, das entsprechende Triggersignal an die Skaliereinheit zu übermitteln, woraufhin die Skaliereinheit selbständig den gesamten an- bzw. absteigenden Amplitudenverlauf erzeugen kann. Dadurch wird die Steuerung der Skaliereinheit vereinfacht.

Insbesondere ist es von Vorteil, wenn jeweils zu einem definierten Zeitpunkt der Einschalt- bzw. Ausschaltrampen ein Triggersignal zu der Skaliereinheit übermittelt wird, wobei insbesondere der zeitliche Abstand zwischen dem Beginn der Einschalt- bzw. Ausschaltrampe und dem Triggersignal frei wählbar ist. Der Sollwert der Sendeleistung wird in Form einer Einschalt- bzw. Ausschaltrampe an die Leistungsregelung des Leistungsverstärkers übermittelt. Es soll zunächst die Einschaltrampe betrachtet werden. Der stetig zunehmende Sollwert bewirkt, dass der Verstärkungsfaktor des Leistungsverstärker immer weiter nach oben geregelt wird. Nun wird zu einem definierten Zeitpunkt ein Triggersignal an die Skaliereinheit übermittelt, durch das die Skaliereinheit veranlasst wird, die Amplituden der Basisband-Sendesignale entsprechend dem abgespeicherten Verlauf kontinuierlich anzuheben. Die Signalamplitude am Eingang des Leistungsverstärkers nimmt daher kontinuierlich zu, und deshalb kann der durch die Einschaltrampe vorgegebene Anstieg der Ausgangsleistung ohne nennenswerte weitere Erhöhung der Verstärkung erzielt werden. Mit dem Triggersignal wird also der erfindungsgemäße Mechanismus zur Skalierung der Signalamplituden aktiviert, wobei die zeitliche Synchronisation zwischen der Regelung des Verstärkungsfaktors einerseits und der Amplitudenskalierung andererseits durch den zeitlichen Abstand zwischen dem Beginn der Signalrampe und dem Triggersignal vorgegeben wird. Durch eine geeignete zeitliche Abstimmung zwischen dem Sollwertverlauf für die Leistungsregelung einerseits und der Amplitudenskalierung andererseits kann ein optimales Verhältnis zwischen dem Verlauf der Signalamplitude und dem Verlauf der Verstärkungsregelung gewählt werden.

Beim Abschalten der Sendeleistung wird mit Hilfe der Ausschaltrampe ein absteigender Verlauf für den Sollwert der Sendeleistung vorgegeben. Dementsprechend wird kontinuierlich die Verstärkung des Leistungsverstärkers reduziert. Zu einem definierten Zeitpunkt der Ausschaltrampe wird ein Triggersignal an die Skaliereinheit übermittelt, woraufhin die Skaliereinheit die Amplituden der Basisband-Sendesignale kontinuierlich reduziert. Dadurch wird die Sendeleistung kontinuierlich weiter abgesenkt, ohne dass hierfür eine nennenswerte weitere Reduzierung der Verstärkung notwendig wäre.

Die Erfindung ist insbesondere für den Einsatz in Mobilfunkstationen geeignet, da sie sich mit geringem baulichen Aufwand in digitaler Technologie realisieren lässt. Insbesondere eignet sich die Erfindung für den Einsatz in Mobilfunkstationen, bei denen die Datenübertragung entsprechend einem der Standards GSM, EDGE, TIA-/EIA-136, UMTS oder entsprechend von Teilkombinationen dieser Standards erfolgt. Eine Gemeinsamkeit der genannten Mobilfunkstandards ist, dass die Datenübertragung in Form von Datenbursts erfolgt. Insofern ist es bei den genannten Standards erforderlich, die Sendeleistung vor Beginn der Übertragung eines Datenbursts hoch- und nach Beendigung der Übertragung wieder herunterzufahren. Aus diesem Grund eignen sich Mobilfunkstationen, die einen der genannten Standards bzw. Teilkombinationen dieser Standards unterstützen, für den Einsatz der erfindungsgemäßen Skalierung der Basisband-Sendesignale.

Das erfindungsgemäße Verfahren eignet sich zum Herauffahren der sendeleistung von Funkgeräten, insbesondere von Mobilfunkgeräten, welche mindestens einen Hochfrequenz-Baustein aufweisen, wobei der Hochfrequenz-Baustein Basisband-Sendesignale in den Hochfrequenzbereich umsetzt, verstärkt und dazu einen Leistungsverstärker mit einstellbarer Verstärkung aufweist.
Das Herauffahren der Sendeleistung findet dabei vor der Übermittelung eines Datenbursts statt. Bei der Durchführung des erfindungsgemäßen Verfahrens zum Herauffahren der Sendeleistung wird in einem ersten Schritt eine Einschaltrampe an eine Leistungsregelung für die Sendeleistung angelegt, so dass die Verstärkung des Leistungsverstärkers zunimmt. Ab einem definierten Zeitpunkt der Einschaltrampe werden dann die Amplituden der Basisband-Sendesignale simultan zum Verlauf der Einschaltrampe stetig von einem Minimalwert auf einen Maximalwert erhöht.

Das erfindungsgemäße Verfahren zum Herauf fahren der Sendeleistung ermöglicht es, zwei verschiedene Regelungsmechanismen so zu kombinieren und zu synchronisieren, dass insgesamt eine Erhöhung des steuerbaren Dynamikbereichs erzielt werden kann. Dies gilt auch für das weitgehend analoge Verfahren zum Herunterfahren der Sendeleistung von Mobilfunkgeräten.

Nachfolgend wird die Erfindung anhand eines in der Zeichnung dargestellten Ausführungsbeispiels weiter beschrieben. Es zeigen:
- Fig. 1: ein Blockschaltbild der erfindungsgemäßen Leistungsregelung;
- Fig. 2A: den zeitlichen Verlauf der Einschalt- sowie der Ausschaltrampe für die Sendeleistung;
- Fig. 2B: den Amplitudenverlauf der Basisband-Sendesignale beim Einschalt- sowie beim Ausschaltvorgang; sowie
- Fig. 2C: den zeitlichen Verlauf des Stellsignals des Leistungsverstärkers beim Herauf- und Herabfahren der Sendeleistung.

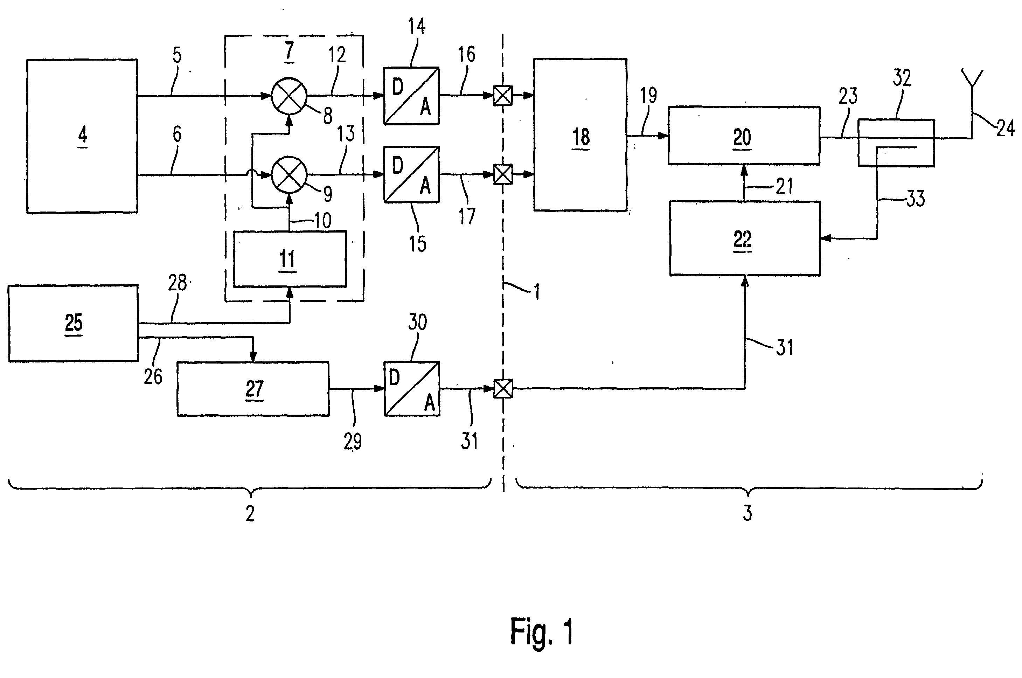

In Fig. 1 ist die erfindungsgemäße Schaltungsanordnung in Form eines Blockschaltbilds dargestellt. Die funktionellen Einheiten auf der Basisbandseite 2, also links von der Bausteingrenze 1, sind auf einem oder mehreren Basisband-Bausteinen angeordnet. Die funktionellen Einheiten auf der Hochfrequenzseite 3, also rechts von der Bausteingrenze 1, sind für die Hochfrequenz-Signalverarbeitung zuständig; diese funktionellen Einheiten sind auf einem oder mehreren Hochfrequenz-Bausteinen integriert.

Durch den Basisband-Modulator 4 werden digitale Basisbandsignale, nämlich ein digitales Inphasesignal 5 sowie ein digitales Quadratursignal 6 erzeugt und an die IQ-Skaliereinheit 7 übermittelt. In der IQ-Skaliereinheit 7 sind ein Multiplizierer 8 für den Inphase-Signalpfad sowie ein Multiplizierer 9 für den Quadratur-Signalpfad angeordnet. Diese Multiplizierer sind als digitale Multiplizierer ausgeführt, wobei die Skalierungswerte 10, mit denen das Inphasesignal 5 sowie das Quadratur-Signal 6 multipliziert werden, von der IQ-Skaliertabelle 11 bereitgestellt werden. Die IQ-Skaliertabelle 11 umfasst einen digitalen Speicher zur Abspeicherung von mindestens einer Abfolge von digitalen Skalierungswerten. Am Ausgang des Multiplizierers 8 kann das skalierte digitale Inphasesignal 12 abgegriffen werden, welches dem Digital-/Analog-Wandler 14 zugeführt wird und dort in das analoge Inphasesignal 16umgewandelt wird. Entsprechend wird das skalierte digitale Quadratursignal 13 dem Digital-/Analog-Wandler 15 zugeführt und in das analoge Quadratursignal 17 umgewandelt. Sowohl das analoge Inphasesignal 16 als auch das analoge Quadratursignal 17 werden von der Basisbandseite 2 zur Hochfrequenzseite 3 geführt und dort durch den Hochfrequenz-Modulator 18 in den Radiofrequenzbereich hochgemischt. Das vom Hochfrequenz-Modulator 18 erzeugte analoge Hochfrequenzsignal dient als Eingangssignal 19 des Leistungsverstärkers 20. Der Verstärkungsfaktor des Leistungsverstärkers 20 wird durch das analoge Stellsignal 21 von der Leistungsregelung 22 vorgegeben. Das am Ausgang des Leistungsverstärkers 20 anliegende verstärkte Hochfrequenzsignal 23 wird der Antenne 24 zugeführt und abgestrahlt.

Für die Steuerung des Einschalt- und des Ausschaltvorgangs ist auf der Basisbandseite 2 ein Steuergerät 25 vorgesehen, welches einerseits die Steuersignale 26 für den Leistungsrampen-Generator 27, sowie andererseits die Triggersignale 28 für die IQ-Skaliereinheit 7 erzeugt. Vom Steuergerät 25 aus können die IQ-Skaliereinheit 7 und der Leistungsrampen-Generator 27 aktiviert, deaktiviert und konfiguriert werden. Mit den Steuersignalen 26 wird der Leistungsrampen-Generator 27 zur Erzeugung einer Einschalt- bzw. einer Ausschaltrampe für die Sendeleistung veranlasst. Das digitale Leistungsrampensignal 29 wird durch den Digital-/Analog-Wandler 30 in das analoge Leistungsrampensignal 31 umgewandelt, das von der Basisbandseite 2 zur Hochfrequenzseite 3 übermittelt wird.

Das analoge Leistungsrampensignal 31 wird der Leistungsregelung 22 zugeführt und dient als Sollwertvorgabe für die Ausgangssendeleistung der Mobilstation. Der Istwert der Ausgangssendeleistung wird in der Leistungsmesseinheit 32 erfasst, indem ein Bruchteil des hochfrequenten Sendesignals ausgekoppelt und insbesondere gleichgerichtet wird. Das von der Leistungsmesseinheit 32 ausgegebene Leistungsmesssignal 33 stellt ein Maß für die tatsächlich an der Antenne 24 auftretende Ausgangssendeleistung, also den Istwert der Sendeleistung, dar und wird der Leistungsregelung 22 zugeführt.

Die Leistungsregelung 22 ist als Regelkreis realisiert. Um das Stellsignal 21 für den Leistungsverstärker 20 zu erzeugen, wird ständig ein Vergleich zwischen dem als Sollwert dienenden analogen Leistungsrampensignal 31 und dem den Istwert repräsentierenden Leistungsmesssignal 33 durchgeführt. Wenn der durch das Leistungsrampensignal 31 vorgegebene Sollwert höher ist als der Istwert, dann wird das Stellsignal 21 so nachgestellt, dass die Verstärkung des Leistungsverstärkers 20 erhöht wird. Wenn umgekehrt der durch das Leistungsmesssignal 33 angezeigte aktuelle Wert der Sendeleistung den durch das analoge Leistungsrampensignal 31 dargestellten Sollwert übersteigt, dann wird die Ausgangssendeleistung gedrosselt. Dazu wird der Verstärkungsfaktor des Leistungsverstärkers 20 abgesenkt.

Mit Hilfe dieses Leistungsregelkreises wird sichergestellt, dass die Ausgangssendeleistung jeweils dem durch das Leistungsrampensignal vorgegebenen Verlauf folgt. Mit dem beschriebenen Regelkreis lässt sich dies unabhängig von der Signalamplitude des Eingangssignals 19 stets gewährleisten.

Zur Erzeugung einer Einschaltrampe wird in einem gewissen zeitlichen Abstand zum Steuersignal 26, welches den Leistungsrampen-Generator 27 zur Erzeugung der Einschaltrampe veranlasst, ein Triggersignal 28 an die IQ-Skaliereinheit 7 übermittelt, das zur Unterstützung des Einschaltvorgangs einen ansteigenden Verlauf der Skalierungswerte 10 für die Basisband-Sendesignale veranlasst. Die ansteigende Abfolge von Skalierungswerten 10 ist in der IQ-Skaliertabelle 11 abgelegt. Die Skalierungswerte werden nacheinander ausgelesen und an die Multiplizierer 8 und 9 übermittelt, damit das digitale Inphasesignal 5 und das digitale Quadratursignal 6 mit diesen Faktoren multipliziert werden können. Dadurch ergibt sich ein ansteigender Verlauf der skalierten digitalen Signale 12 und 13, und dadurch wird der Einschaltvorgang unterstützt. Die Skalierung der IQ-Signale sollte im gesamten Verlauf und insbesondere am Anfang und Ende der IQ-Rampe einen stetigen und differenzierbaren Verlauf haben, damit die Leistungsverstärkerregelung keine abrupten Übergänge ausregeln muss.

Wenn der Leistungsrampen-Generator 27 dagegen ein Steuersignal 26 übermittelt bekommt, welches die Erzeugung einer Ausschaltrampe veranlasst, dann wird in gewissem zeitlichen Abstand zu diesem Steuersignal 26 ein Triggersignal 28 an die IQ-Skaliereinheit 7 übermittelt, welches einen abfallenden Verlauf der Skalierung für die Basisband-Sendesignale antriggert. Hierzu wird eine abfallende Sequenz von Skalierungswerten aus der IQ-Skaliertabelle 11 ausgelesen und an die Multiplizierer 8 und 9 übermittelt. Die absteigende Sequenz von Skalierungswerten kann als separate Folge von Skalierungsdaten abgespeichert sein. Zur Erzeugung der absteigenden Sequenz von Skalierungswerten kann aber auch die in Zusammenhang mit der Einschaltrampe verwendete ansteigende Sequenz von Skalierungswerten in umgekehrter Reihenfolge ausgelesen werden.

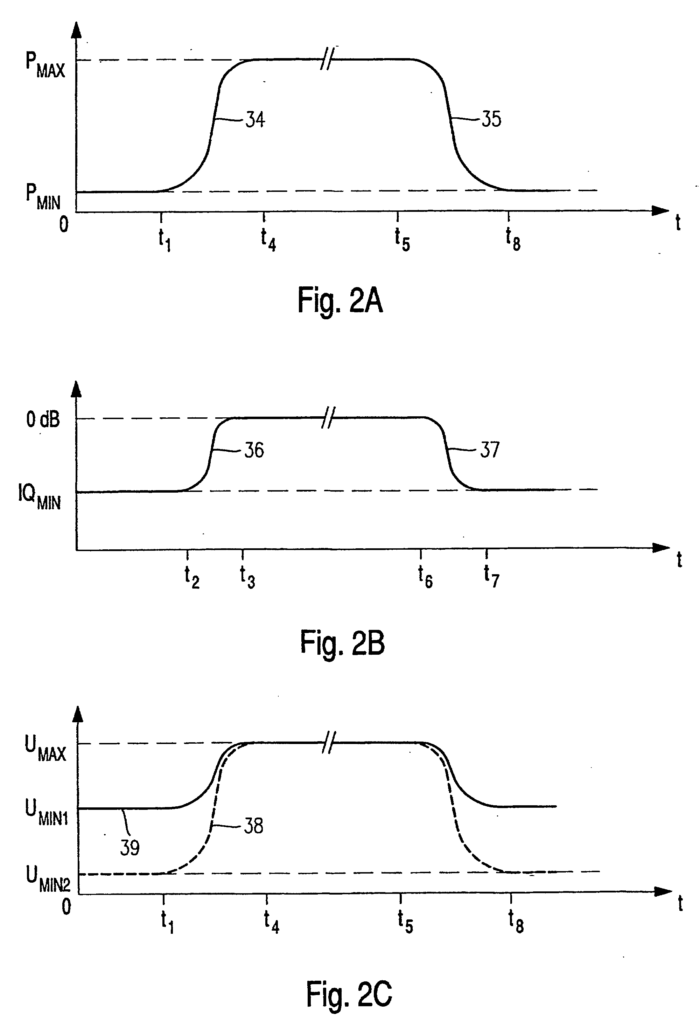

In den Fig. 2A bis 2C sind die verschiedenen, für die Erzeugung einer Einschaltrampe bzw. einer Ausschaltrampe benötigten Signale in ihrem zeitlichen Verlauf gezeigt. In Fig. 2A ist die Ausgangsleistung des Leistungsverstärkers als Funktion der Zeit aufgetragen, wobei im zeitlichen Verlauf eine Einschaltrampe 34 und anschließend eine Ausschaltrampe 35 durchfahren wird. Der Verlauf der Einschalt- und der Ausschaltrampe wird durch das analoge Leistungsrampensignal 31 vorgegeben, dessen zeitlicher Verlauf deshalb dem gezeigten Verlauf der Ausgangsleistung prinzipiell entspricht.

Der Zeitpunkt t₁ markiert den Beginn der Einschaltrampe 34. In der Folge kommt es zu einem Anstieg der Ausgangsleistung des Leistungsverstärkers von der minimalen Ausgangsleistung P_{MIN} bis zur maximalen Ausgangsleistung P_{MAX}. Zum Zeitpunkt t₄ hat die Leistungsrampe nach fester Ablaufzeit das Maximum erreicht.

Die Ausschaltrampe 35 beginnt zum Zeitpunkt t₅. Daraufhin kommt es zu einem Abfall der Ausgangsleistung vom Wert P_{MAX} (maximale Ausgangsleistung) bis zum Wert P_{MIN} (minimale Ausgangsleistung). Zum Zeitpunkt t₈ hat die Leistungsrampe nach fester Ablaufzeit das Minimum erreicht.

In Fig. 2B ist der zugehörige zeitliche Verlauf der Leistung des komplexen Basisbandsignals gezeigt. Die Leistung des komplexen Basisbandsignals lässt sich aus dem skalierten analogen Inphasesignal 16 und dem skalierten analogen Quadratursignal 17 ableiten. Der in Fig. 2B gezeigte Verlauf gibt insofern die Skalierung der Basisband-Sendesignale durch die IQ-Skaliereinheit 7 wieder. Anfangs befindet sich die Ausgangsleistung auf ihrem Minimalwert, und auch die Leistung des komplexen Basisbandsignals ist auf einen Minimalwert herunterskaliert. Der eingezeichnete Wert IQ_{MIN} gibt den Minimalwert der Leistung des komplexen Basisbandsignals relativ zum Maximalwert an. Ab dem Zeitpunkt t₁, zu dem die Einschaltrampe aktiviert wird, beginnt im Steuergerät 25 eine beliebig festlegbare Zeitspanne zu laufen. Nach Ablauf dieser Zeitspanne, zum Zeitpunkt t₂, wird ein Triggersignal 28 an die IQ-Skaliereinheit 7 übermittelt, die den IQ-Skalierungsanstieg 36 für die Einschaltrampe aktiviert. Zum Zeitpunkt t₃ hat die IQ-Skalierung nach fester Ablaufzeit das Maximum erreicht.

Entsprechend wird zum Zeitpunkt t₆, der sich in frei wählbarem zeitlichem Abstand zum Zeitpunkt t₅ befindet, der IQ-Skalierungsabfall 37 für die Ausschaltrampe aktiviert. Dies geschieht wieder mit Hilfe eines Triggersignals 28. Zum Zeitpunkt t₇ hat die Skalierung der Basisband-Sendesignale nach fester Ablaufzeit wieder das Minimum IQ_{MIN} ereicht.

Fig. 2C zeigt den zeitlichen Verlauf des analogen Stellsignals 21, mit dem der Verstärkungsfaktor des Leistungsverstärkers 20 eingestellt wird. Der Signalverlauf 38, der als gestrichelte Linie eingezeichnet ist, bezieht sich auf den Fall einer konstanten Amplitude des Inphasesignals 16 sowie des Quadratursignals 17, wie es dem Stand der Technik entspricht. Ohne die erfindungsgemäße IQ-Skalierung muss der Verstärkungsfaktor des Leistungsverstärkers 20 über einen weiten Dynamikbereich hinweg variiert werden, und deshalb muss auch das Stellsignal 21 einen großen Spannungsbereich von der Minimalspannung U_{MIN2} bis zur Maximalspannung U_{MAX} und zurück zur Minimalspannung U_{MIN2} durchlaufen.

Der als durchgezogene Linie eingezeichnete Signalverlauf 39 gibt den Verlauf des Stellsignals 21 bei Einsatz der erfindungsgemäßen IQ-Skalierung wieder. Da das analoge Inphasesignal 16 sowie das analoge Quadratursignal 17 entsprechend dem in Fig. 2B gezeigten Verlauf skaliert werden, muss der Verstärkungsfaktor des Leistungsverstärkers 20 während des Einschalt- bzw. Ausschaltvorgangs weniger stark variiert werden, als dies im Stand der Technik der Fall war. Deshalb umfasst auch das Stellsignal 21 für den Leistungsverstärker einen kleineren Wertebereich, der sich von der Minimalspannung U_{MIN1} bis zur Maximalspannung U_{MAX} erstreckt.

Durch Einsatz der erfindungsgemäßen IQ-Skalierung muss der Verstärkungsfaktor des Leistungsverstärkers 20 daher in wesentlich geringerem Umfang verändert werden als bisher, um einen vorgegebenen Dynamikbereich für die Sendeleistung zu realisieren. Umgekehrt lässt sich durch den Einsatz der erfindungsgemäßen Skalierung der Signalamplituden von Inphase- und Quadratursignal der Dynamikbereich der Ausgangssendeleistung gegenüber dem Stand der Technik erhöhen.

## Patentansprüche

1. Vorrichtung zur Kontrolle der Ausgangsleistung von Funkgeräten, insbesondere von Mobilfunkgeräten, mit
- mindestens einem Hochfrequenz-Baustein, welcher Basisband-Sendesignale in den Hochfrequenzbereich umsetzt und verstärkt, wobei der mindestens eine Hochfrequenz-Baustein einen Leistungsverstärker (20) mit einstellbarer Verstärkung aufweist,
- einer Skaliereinheit (7), mit der die Signalamplituden der Basisband-Sendesignale variierbar sind, und
- einem Steuergerät (25), welches bei Herauf- oder Herunterfahren der Ausgangsleistung vor bzw. nach der Übermittelung eines Datenbursts die Veränderung der Signalamplituden der Basisband-Sendesignale durch die Skaliereinheit (7) mit der Veränderung der Verstärkung des Leistungsverstärkers (20) synchronisiert.

2. Vorrichtung nach Anspruch 1,
**dadurch gekennzeichnet,**
**dass** die Skaliereinheit (7) für jedes Basisband-Sendesignal einen Multiplizierer (8, 9) umfasst, mit dem die Signalamplitude des jeweiligen Basisbandsignals skaliert werden kann.

3. Vorrichtung nach Anspruch 2,
**dadurch gekennzeichnet,**
**dass** es sich bei den Multiplizierern (8, 9) um digitale Multiplizierer handelt, die im Signalpfad vor den Digital-/Analog-Wandlern (14, 15) angeordnet sind.

4. Vorrichtung nach einem der vorhergehenden Ansprüche,
**dadurch gekennzeichnet,**
**dass** die Vorrichtung mindestens einen Basisband-Baustein umfasst, der die Basisband-Sendesignale erzeugt, und dass die Skaliereinheit (7) auf dem Basisband-Baustein angeordnet ist.

5. Vorrichtung nach einem der vorhergehenden Ansprüche,
**dadurch gekennzeichnet,**
**dass** die Basisband-Sendesignale ein Inphasesignal (16) sowie ein Quadratursignal (17) umfassen.

6. Vorrichtung nach einem der vorhergehenden Ansprüche,
**dadurch gekennzeichnet,**
**dass** die Verstärkung des Leistungsverstärkers durch eine Leistungsregelung (22) steuerbar ist.

7. Vorrichtung nach Anspruch 6,
**dadurch gekennzeichnet,**
**dass** die Verstärkung des Leistungsverstärkers (20) durch die Leistungsregelung (22) so nachgeregelt wird, dass die tatsächliche Sendeleistung jeweils einem der Leistungsregelung (22) zugeführten Sollwert (31) der Sendeleistung entspricht.

8. Vorrichtung nach einem der vorhergehenden Ansprüche,
**dadurch gekennzeichnet,**
**dass** die Vorrichtung eine Leistungsmesseinheit (32) zur Bestimmung der tatsächlichen Sendeleistung aufweist, welche einen Bruchteil der Sendeleistung auskoppelt und auswertet.

9. Vorrichtung nach einem der vorhergehenden Ansprüche,
**dadurch gekennzeichnet,**
**dass** die Vorrichtung einen Leistungsrampen-Generator (27) zur Erzeugung von stetig verlaufenden Einschalt- bzw. Ausschaltrampen (34, 35) für den Sollwert (31) der Sendeleistung umfasst.

10. Vorrichtung nach Anspruch 9,
**dadurch gekennzeichnet,**
**dass** der Leistungsrampen-Generator (27) auf dem Baustein angeordnet ist, der die Skaliereinheit (7) enthält.

11. Vorrichtung nach einem der vorhergehenden Ansprüche,
**dadurch gekennzeichnet,**
**dass** die Skaliereinheit (7) einen Speicher (11) für eine Abfolge von an- bzw. absteigenden Amplitudenwerten aufweist, womit ein an- bzw. absteigender Verlauf (36, 37) der Amplituden der Basisband-sendesignale erzeugbar ist.

12. Vorrichtung nach Anspruch 11,
**dadurch gekennzeichnet,**
**dass** der an- bzw. absteigende. Verlauf (36, 37) der Basisband-Sendesignale durch Triggersignale (28) initiiert wird, die der Skaliereinheit (7) zugeführt werden.

13. Vorrichtung nach Anspruch 11 oder Anspruch 12,
**dadurch gekennzeichnet,**
**dass** jeweils zu einem definierten Zeitpunkt der Einschalt- bzw. Ausschaltrampen ein Triggersignal (28) zu der Skaliereinheit (7) übermittelt wird, wobei insbesondere der zeitliche Abstand zwischen dem Beginn der Einschalt- bzw. Ausschaltrampe und dem Triggersignal (28) frei wählbar ist.

14. Mobilfunkstation, welche eine Vorrichtung entsprechend einem der Ansprüche 1 bis 13 aufweist.

15. Mobilfunkstation nach Anspruch 14,
**dadurch gekennzeichnet,**
**dass** die Datenübertragung entsprechend einem der Standards GSM, EDGE, TIA-/EIA-136, UTRA-TDD, UMTS oder entsprechend von Teilkombinationen dieser Standards erfolgt.

16. Verfahren zum Herauffahren der Sendeleistung von Funkgeräten, insbesondere von Mobilfunkgeräten, welche mindestens einen Hochfrequenz-Baustein aufweisen, wobei der Hochfrequenz-Baustein Basisband-Sendesignale in den Hochfrequenzbereich umsetzt, verstärkt und dazu einen Leistungsverstärker (20) mit einstellbarer Verstärkung aufweist, vor der Übermittelung eines Datenbursts, mit folgenden Schritten:
a) Anlegen einer Einschaltrampe (34) an eine Leistungsregelung (22) für die Sendeleistung, so dass die Verstärkung des Leistungsverstärkers zunimmt;
b) beginnend mit einem definierten Zeitpunkt der Einschaltrampe, stetiges Erhöhen (36) der Amplituden der Basisband-Sendesignale von einem Minimalwert auf einen Maximalwert simultan zum Verlauf der Einschaltrampe (34).

17. Verfahren zum Herunterfahren der Sendeleistung von Funkgeräten, insbesondere von Mobilfunkgeräten, welche mindestens einen Hochfrequenz-Baustein aufweisen, wobei der Hochfrequenz-Baustein Basisband-Sendesignale in den Hochfrequenzbereich umsetzt, verstärkt und dazu einen Leistungsverstärker (20) mit einstellbarer Verstärkung aufweist, nach der Übermittelung eines Datenbursts, mit folgenden Schritten:
a) Anlegen einer Ausschaltrampe (35) an eine Leistungsregelung (22) für die Sendeleistung, so dass die Verstärkung des Leistungsverstärkers abnimmt;
b) beginnend mit einem definierten Zeitpunkt der Ausschaltrampe, stetiges Verringern (37) der Amplituden der Basisband-Sendesignale von einem Maximalwert auf einen Minimalwert simultan zum Verlauf der Ausschaltrampe (35).

## Claims

1. Device for monitoring the output power of radios, in particular of mobile radios, having
- at least one radio-frequency module which converts baseband transmission signals to the radio-frequency band and amplifies them, the at least one radio-frequency module having a variable gain power amplifier (20)
- a scaling unit (7) by means of which the signal amplitudes of the baseband transmission signals can be varied, and
a controller (25) which, when increasing or decreasing the output power before and after the transmission of a data burst, synchronizes the change in the signal amplitudes of the baseband transmission signals by the scaling unit (7) with the change in the gain of the power amplifier (20).

2. Device according to Claim 1,
**characterized**
**in that** the scaling unit (7) has a multiplier (8, 9) for each baseband transmission signal, by means of which the signal amplitude of the respective baseband signal can be scaled.

3. Device according to Claim 2,
**characterized**
**in that** the multipliers (8, 9) are digital multipliers which are arranged upstream of the digital/analogue converters (14, 15) in the signal path.

4. Device according to one of the preceding claims,
**characterized**
**in that** the device has at least one baseband module which produces baseband transmission signals, and in that the scaling unit (7) is arranged on the baseband module.

5. Device according to one of the preceding claims,
**characterized**
**in that** the baseband transmission signals comprise an in-phase signal (16) and a quadrature signal (17).

6. Device according to one of the preceding claims,
**characterized**
**in that** the gain of the power amplifier can be controlled by power control (22).

7. Device according to Claim 6,
**characterized**
**in that** the gain of the power amplifier (20) is readjusted by the power control (22) such that the actual transmission power in each case corresponds to a nominal value (31) of the transmission power which is supplied to the power control (22).

8. Device according to one of the preceding claims,
**characterized**
**in that** the device has a power measurement unit (32) for determining the actual transmission power, which outputs and evaluates a fraction of the transmission power.

9. Device according to one of the preceding claims,
**characterized**
**in that** the device has a power ramp generator (27) for producing switching-on and switching-off ramps (34, 35), which have a continuous profile, for the nominal value (31) of the transmission power.

10. Device according to Claim 9,
**characterized**
**in that** the power ramp generator (27) is arranged on the module which contains the scaling unit (7).

11. Device according to one of the preceding claims,
**characterized**
**in that** the scaling unit (7) has a memory (11) for a sequence of rising or falling amplitude values, by means of which a rising or falling profile (36, 37) can be produced for the amplitudes of the baseband transmission signals.

12. Device according to Claim 11,
**characterized**
**in that** the rising or falling profile (36, 37) for the baseband transmission signals is initiated by means of trigger signals (28) which are supplied to the scaling unit (7).

13. Device according to Claim 11 or Claim 12,
**characterized**
**in that** a trigger signal (28) is in each case transmitted to the scaling unit (7) at a defined time in the switching-on and switching-off ramps, in which case, in particular, the time interval between the start of the switching-on or switching-off ramp and the trigger signal (28) can be chosen freely.

14. Mobile radio station which has a device according to one of Claims 1 to 13.

15. Mobile radio station according to Claim 14,
**characterized**
**in that** the data is transmitted in accordance with one of the Standards GSM, EDGE, TIA-/EIA-136, UTRA-TDD, UMTS or in accordance with partial combinations of these Standards.

16. Method for raising the transmission power of radios, in particular of mobile radios, which have at least one radio-frequency module, with the radio-frequency module converting baseband transmission signals to the radio-frequency band, amplifying them and for this purpose having a variable gain power amplifier (20), before the transmission of a data burst having the following steps:
a) application of a switching-on ramp (34) to power control (22) for the transmission power, so that the gain of the power amplifier increases;
b) starting at a defined time on the switch-on ramp, continuously increasing (36) the amplitudes of the baseband transmission signals from a minimum value to a maximum value simultaneously with the profile of the switching-on ramp (34).

17. Method for reducing the transmission power of radios, in particular of mobile radios, which have at least one radio-frequency module, with the radio-frequency module converting baseband transmission signals to the radio-frequency band, amplifying them and for this purpose having a variable gain power amplifier (20), after the transmission of a data burst, having the following steps:
a) application of a switching-off ramp (35) to power control (22) for the transmission power, so that the gain of the power amplifier decreases;
b) starting at a defined time on the switch-on ramp, continuously reducing (37) the amplitudes of the baseband transmission signals from a maximum value to a minimum value simultaneously with the profile of the switching-off ramp (35).

## Revendications

1. Dispositif pour régler la puissance de sortie d'appareils de radio communication mobiles, notamment des appareils de radio communication mobiles, comportant
- au moins un module de haute fréquence qui transforme et amplifie des signaux d'émission en bande de base dans le domaine de haute fréquence, le au moins un module de haute fréquence comportant un amplificateur (20) de puissance ayant un gain réglable,
- une unité (7) de changement d'échelle, avec laquelle les amplitudes de signal des signaux d'émission en bande de base peuvent être modifiées, et
- un dispositif (25) de commande, qui lors de l'augmentation ou la diminution de la puissance de sortie avant ou après la transmission d'un paquet de données synchronise la modification des amplitudes de signal des signaux d'émission en bande de base par l'unité (7) de changement d'échelle avec la modification du gain d'amplification de l'amplificateur (20) de puissance.

2. Dispositif suivant la revendication 1,
**caractérisé en ce que** l'unité (7) de changement d'échelle comporte pour chaque signal d'émission en bande de base un multiplicateur (8, 9), avec lequel on peut mettre à l'échelle l'amplitude de signal du signal en bande de base associé.

3. Dispositif suivant la revendication 2,
**caractérisé en ce que** les multiplicateurs (8, 9) sont des multiplicateurs numériques, qui sont disposés dans la voie de signal avant le convertisseur (14, 15) numérique/analogique.

4. Dispositif suivant l'une des revendications précédentes,
**caractérisé en ce que** le dispositif comporte au moins un module de bande de base, qui produit les signaux d'émission en bande de base et **en ce que** l'unité (7) de changement d'échelle est disposée sur le module en bande de base.

5. Dispositif suivant l'une des revendications précédentes,
**caractérisé en ce que** les signaux d'émission en bande de base comportent un signal (16) en phase ainsi qu'un signal (17) en quadrature.

6. Dispositif suivant l'une des revendications précédentes,
**caractérisé en ce que** le gain d'amplification de l'amplificateur de puissance peut être commandé par un dispositif (22) de régulation de puissance.

7. Dispositif suivant la revendication 6,
**caractérisé en ce que** le gain de l'amplificateur (20) de puissance peut être réajusté par le dispositif (22) de régulation de puissance, de telle sorte que la puissance d'émission réelle correspond chaque fois à une valeur (31) de consigne envoyée au dispositif (22) de régulation de puissance.

8. Dispositif suivant l'une des revendications précédentes,
**caractérisé en ce que** le dispositif comporte une unité (32) de mesure de puissance pour déterminer la puissance d'émission réelle, qui découple et exploite une fraction de la puissance d'émission.

9. Dispositif suivant l'une des revendications précédentes,
**caractérisé en ce que** le dispositif comporte un générateur (27) de rampe de puissance destiné à produire des rampes (34, 35) de connexion et de déconnexion qui varient en permanence pour la valeur (31) de consigne de la puissance d'émission.

10. Dispositif suivant la revendication 9,
**caractérisé en ce que** le générateur (27) de rampe de puissance est disposé sur le module, qui contient l'unité (7) de changement d'échelle.

11. Dispositif suivant l'une des revendications précédentes,
**caractérisé en ce que** l'unité (7) de changement d'échelle comporte une mémoire (11) pour une suite de valeurs d'amplitude croissantes ou décroissantes, une courbe (36, 37) croissante ou décroissante des amplitudes des signaux d'émission de bande de base pouvant être produite.

12. Dispositif suivant la revendication 11,
**caractérisé en ce que** la courbe (36, 37) croissante ou décroissante des signaux d'émission de bande de base est initiée par des signaux (28) de déclenchement qui sont envoyés à l'unité (7) de changement d'échelle.

13. Dispositif suivant la revendication 11 ou 12,
**caractérisé en ce que** chaque fois à un instant défini de la rampe de connexion ou de déconnexion il est transmis un signal (28) de déclenchement à l'unité (7) de changement d'échelle, notamment l'écart temporel entre le début de la rampe de connexion ou de la rampe de déconnexion et le signal (28) de déclenchement pouvant être choisi librement.

14. Station de radio communication mobile, qui comporte un dispositif suivant l'une des revendications 1 à 13.

15. Station de radio communication mobile suivant la revendication 14,
**caractérisé en ce que** la transmission de données s'effectue suivant l'une des normes, GSM, EDGE, TIA-/EIA-136, UTRA-TDD, UMTS ou suivant des combinaisons partielles de ces normes.

16. Procédé d'augmentation de la puissance d'émission d'appareils de radio communication, notamment d'appareils de radio communication mobiles qui ont au moins un module de haute fréquence, le module de haute fréquence transformant des signaux d'émission en bande de base dans le domaine de la haute fréquence, les amplifiant et comportant à cet effet un amplificateur (20) de puissance ayant un gain pouvant être réglé, avant la transmission d'un paquet de données, comportant les stades suivants :
a) Application d'une rampe (34) de connexion à une régulation de puissance (22) pour la puissance d'émission de sorte que le gain de l'amplificateur de puissance augmente ;
b) à partir d'un instant défini dans le temps de la rampe de connexion, augmentation (36) continue des amplitudes des signaux d'émission en bande de base d'une valeur minimum à une valeur maximale simultanément à la variation de la rampe (34) de connexion.

17. Procédé pour diminuer la puissance d'émission d'appareils de radio communication, notamment d'appareils de communication mobile qui comportent au moins un module de haute fréquence, le module de haute fréquence transformant des signaux d'émission en bande de base dans le domaine de la haute fréquence, les amplifiant et ayant à cet effet un amplificateur (20) de puissance à gain réglable, après la transmission d'un paquet de données, comportant les stades suivants :
a) Application d'une rampe (35) de déconnexion à un dispositif (22) de régulation de puissance pour la puissance d'émission, de sorte que le gain de l'amplificateur de puissance diminue ;
b) à partir d'un instant défini dans le temps de la rampe de déconnexion, diminution (37) continue des amplitudes des signaux d'émission en bande de base d'une valeur maximale à une valeur minimale simultanément à la variation de la rampe (35) de connexion.
